# EUROPÄISCHE PATENTSCHRIFT

(11) **EP 1 309 999 B1**
(45) Veröffentlichungstag und Bekanntmachung des Hinweises auf die Patenterteilung: **11.11.2009**
(21) Anmeldenummer: 01956390.7
(22) Anmeldetag: 27.07.2001
(51) Int. Cl.: H01L 23/544

(54) **HALBLEITERBAUELEMENT UND VERFAHREN ZUR IDENTIFIZIERUNG EINES HALBLEITERBAUELEMENTES**
SEMICONDUCTOR COMPONENT AND A METHOD FOR IDENTIFYING A SEMICONDUCTOR COMPONENT
COMPOSANT SEMI-CONDUCTEUR ET PROCEDE POUR IDENTIFIER UN COMPOSANT SEMI-CONDUCTEUR

(30) Priorität: 10.08.2000 DE 10038998
(43) Veröffentlichungstag der Anmeldung: 14.05.2003
(73) Patentinhaber: ROBERT BOSCH GMBH, 70442 Stuttgart (DE)
(72) Erfinder: HAAG, Frieder, 72760 Reutlingen (DE)
(86) Internationale Anmeldenummer: PCT/DE2001/002844
(87) Internationale Veröffentlichungsnummer: WO 2002/013270

(56) Entgegenhaltungen:
- EP-A- 0 311 087
- US-A- 5 834 648
- US-A- 5 909 122
- US-A- 5 984 190
- US-A- 6 089 095
- PATENT ABSTRACTS OF JAPAN vol. 010, no. 319 (E-450), 30. Oktober 1986 (1986-10-30) & JP 61 131549 A (SHARP CORP), 19. Juni 1986 (1986-06-19)

## Beschreibung

### Stand der Technik

Die Erfindung betrifft ein Halbleiterbauelement und ein Verfahren zur Identifizierung eines Halbleiterbauelementes.

Es ist allgemein bekannt, Halbleiterbauelemente im Nutzen auf einem gemeinsamen Basissubstrat, wie beispielsweise einem Silicium-Wafer zu fertigen. Nach der Herstellung der einzelnen mit elektronischen/elektromechanischen Bauteilen versehenen Halbleitersubstrate werden diese vereinzelt, was durch Zersägen des Basissubstrats geschehen kann. Die einzelnen Halbleitersubstrate werden sodann auf den Montageabschnitt eines Leitungsgitters, ein sogenanntes Leadframe, aufgebracht und mit Kontaktabschnitten des Leitungsgitters über Bonddrähte verbunden. In einem als "Transfer molding" bekannten Spritzverfahren, das auch als Transferformen bezeichnet wird, wird anschließend das Halbleitersubstrat bis auf seine durch die Kontaktabschnitte gebildeten Anschlüsse in ein Gehäuseteil aus Spritzmasse eingebettet. Dieses Verfahren ist beispielsweise beschrieben in "Advanced Microsystems for Automotive Applications 99, D.D. Ricken, W. Gessner, Seite 126ff". Oft ist es notwendig, die ursprüngliche Position eines einzelnen Halbleitersubstrats auf dem Basissubstrat nach der Vereinzelung und Herstellung der fertigen Halbleiterbauelemente zu kennen. Dies kann erforderlich sein, um beispielsweise Meßergebnisse von Vormessungen, die auf dem Basissubstrat durchgeführt wurden, mit Meßergebnissen von Endmessungen, die an dem fertig hergestellten und vereinzelten Halbleiterbauelement durchgeführt werden, vergleichen zu können. Deshalb ist eine Kennzeichnung der einzelnen Halbleitersubstrate auf dem Basissubstrat wünschenswert. Optisch erkennbare Kenncodierungen auf den Halbleitersubstraten sind mit dem Nachteil verbunden, daß diese nach der Einbettung der Halbleitersubstrate in das Gehäuseteil von außen nicht mehr identifizierbar sind. Deshalb muß zunächst die Spritzmasse, beispielsweise durch Ätzen, teilweise entfernt werden, damit die Kenncodierung des Halbleitersubstrats optisch erkennbar ist und ausgewertet werden kann. Das geöffnete und teilweise zerstörte Halbleiterbauelement ist dann nicht mehr verwendbar.

Jedes der Dokumente US-A-5 984 190 und US-A-5 909 122 offenbart ein Verfahren zur Identifizierung eines Halbleiterbauelements mittels optischer Erkennung einer Markierung. Das Dokument US-A-5 834 648 offenbart ein Verfahren zur Identifizierung von Gehäusematerialien mittels Ultraschall.

### Vorteile der Erfindung

Das erfindungsgemäße Halbleiterbauelement mit den kennzeichnenden Merkmalen des Anspruchs 1 besitzt den Vorteil, daß eine Identifizierung des Halbleiterbauelementes und eine Erkennung der ursprünglichen Position des in dem Halbleiterbauelement enthaltenen Halbleitersubstrats auf dem Basissubstrat ohne Zerstörung des Halbleiterbauelementes möglich ist. Dies wird durch eine mittelbar oder unmittelbar auf dem Halbleitersubstrat angeordnete Kennung erreicht, die von außerhalb des Gehäuseteils des Halbleiterbauelementes mittels Ultraschall auslesbar ist. Hierbei wird ausgenutzt, daß die Kunststoffmasse des Gehäuseteils für Ultraschall durchlässig ist, so daß mittels einer Ultraschalleinrichtung durch Messen unterschiedlicher Laufwege der eingestrahlten Ultraschallwelle oder durch Messen der an dem Halbleiterbauelement reflektierten Ultraschallwelle ein Abbild der mit der Kennung versehenen Flächenstruktur des Halbleiterbauelementes erzeugt werden kann, welches dann ausgewertet wird, um das Halbleiterbauelement zu identifizieren.

Die Kennung kann prinzipiell auf verschiedene Art hergestellt werden. Besonders einfach ist jedoch, wenn die Kennung durch ein Muster von Vertiefungen in einem Flächenabschnitt des Halbleitersubstrats oder eines darauf angeordneten Bauteils gebildet wird. Die Vertiefungen können beispielsweise durch Ätzen hergestellt werden. Dies ist insbesondere von Vorteil bei Halbleitersensoren bei denen die elektronischen/elektromechanischen Bauteile auf dem Sensor durch Ätzen mikromechanischer Strukturen gebildet werden und mittels eines ebenfalls durch Ätzen hergestellten Kappenteils abgedeckt werden. Die Vertiefungen können dann vorteilhaft an einer dem Halbleitersubstrat zugewandten Innenseite des auf dem Halbleitersubstrat angeordneten Kappenteils ausgebildet werden. Dies ist insbesondere dann vorteilhaft, wenn das Kunststoffmaterial des Gehäuseteils akustisch gut an das Material des Halbleitersubstrats und des Kappenteils angepaßt ist. In diesem Fall ergibt sich nämlich nur eine sehr geringe Reflexion der Ultraschallwelle an der Grenzschicht zwischen dem Gehäuseteil und dem Halbleitersubstrat beziehungsweise dem Kappenteil. Die Kennung ist dann kaum erkennbar. In dem durch das Halbleitersubstrat und das Kappenteil gebildeten Hohlraum befindet sich Gas oder Vakuum, so daß in jedem Fall an der Grenzfläche zwischen der Innenseite des Kappenteils und dem Hohlraum eine akustische Fehlanpassung vorliegt. Die an der Innenseite des Kappenteils angeordneten Kennung ist daher im Ultraschallmikroskop besonders gut erkennbar. Durch anisotropes Ätzen kann erreicht werden, daß die Innenwände der Vertiefungen gegenüber dem Flächenabschnitt, in dem die Vertiefungen hergestellt sind, um einen Winkel geneigt sind, so daß die Ultraschallwellen vorteilhaft im Bereich der Vertiefungen schräg zur Einstrahlrichtung reflektiert werden.

In einem anderen Ausführungsbeispiel ist vorgesehen, daß die auf dem Halbleitersubstrat oder dem Bauteil angeordnete Kennung durch ein Muster gebildet wird, das aus einer Materialschicht oder einem Schichtsystem aus verschiedenen Materialien besteht, in dem sich Ultraschall mit einer anderen Geschwindigkeit ausbreitet als in dem Material des Halbleitersubstrats oder des Bauteils. Hierbei wird ausgenutzt, daß die Aufbringung eines solchen Musters eine akustische Fehlanpassung des Reflexionsvermögen zur Folgen hat, so daß eine Ultraschallwelle an der Grenzfläche zwischen dem Mustermaterial und dem Halbleitersubstrat oder Bauteil, beziehungsweise an den Grenzflächen zweier Schichten eines das Muster bildenden strukturierten Schichtsystems anders reflektiert wird, als an den nicht mit dem Muster versehenen Stellen der Oberfläche des Halbleitersubstrats.

In einem anderen Ausführungsbeispiel ist vorgesehen, das Reflexionsvermögen der Ultraschallwelle durch eine Veränderung des Haftvermögens des Gehäusematerials auf dem Halbleitersubstrat zu verändern. Vorteilhaft kann das Gehäuseteil aus Spritzmasse und die auf dem Halbleitersubstrat oder einem darauf angeordneten Bauteil angeordnete Kennung durch ein Muster gebildet werden, das aus einem Material besteht, an dem die Spritzmasse schlechter haftet als am Material des Halbleitersubstrats oder des Bauteils. Dies kann beispielsweise dadurch erreicht werden, daß die Kennung durch ein Muster aus Silberflecken gebildet wird. Durch Delamination der Spritzmasse an den mit den Silberflecken versehenen Stellen der Oberfläche des Halbleitersubstrats verändert sich die Reflexion der eingestrahlten Ultraschallwelle, so daß die Kennung mittels eines Ultraschallempfängers ausgelesen werden kann. Es ist auch möglich, die auf dem Halbleitersubstrat oder einem darauf angeordneten Bauteil angeordnete Kennung durch ein Muster zu bilden, das aus einem Material besteht, an dem die Spritzmasse besser haftet als am Material des Halbleiterbauelementes oder des Bauteils. Beispielsweise kann die Kennung auf dem Halbleiterbauelement durch ein Muster aus Polyimidflecken gebildet werden, an dem die Spritzmasse des Gehäuseteils besser haftet als an dem Halbleitersubstrat.

Vorteilhaft ist weiterhin ein Verfahren zur Identifizierung eines Halbleiterbauelementes, das wenigstens ein mit elektronischen/elektromechanischen Bauteilen versehenes Halbleitersubstrat aufweist, das zusammen mit einer Vielzahl weiterer Halbleitersubstrate auf einem gemeinsamen Basissubstrat im Nutzen hergestellt wird, wobei die Halbleitersubstrate nach der Herstellung vereinzelt und auf ein Leitungsgitter aufgebracht werden und schließlich bis auf ihre jeweiligen Anschlüsse mit einem Gehäuseteil umgeben werden und bei dem alle Halbleitersubstrate des Nutzens vor der Vereinzelung mit einer die Position des jeweiligen Halbleitersubstrats auf dem Basissubstrat bezeichnenden, mittelbar oder unmittelbar auf dem Halbleitersubstrat angeordneten Kennung versehen werden und die Kennung eines ausgewählten Halbleitersubstrats nach dem Vereinzeln und Einbringen in das Gehäuseteil zur Identifizierung des Halbleiterbauelementes mittels einer Ultraschalleinrichtung von außerhalb des Gehäuseteils ausgelesen wird. Als Ultraschalleinrichtung kann vorteilhaft ein Ultraschallmikroskop verwandt werden.

### Zeichnungen

Ausführungsbeispiele der Erfindung sind in den Zeichnungen dargestellt und werden in der nachfolgenden Beschreibung erläutert. Es zeigt
Fig. 1 einen Querschnitt durch ein erfindungsgemäßes Halbleiterbauelement mit einer an der Innenseite eines Kappenteils angeordneten Ultraschall-Kennung,
Fig. 2 eine Draufsicht auf einen Halbleiterbauelement-Nutzen,
Fig. 3a und 3b einen Querschnitt und eine Draufsicht auf ein mit einem Kappenteil versehenes Halbleitersubstrat vor der Einbringung in ein Gehäuseteil.

### Beschreibung der Ausführungsbeispiele

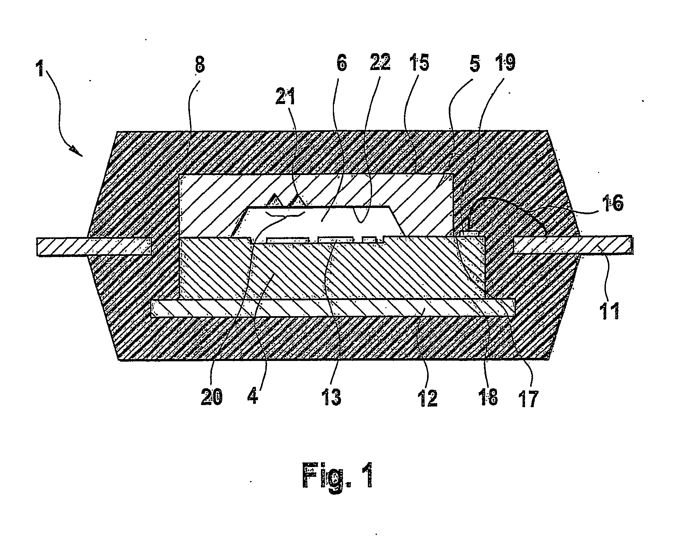

Fig. 1 zeigt ein erfindungsgemäßes Halbleiterbauelement im Querschnitt. Das dargestellte Halbleiterbauelement 1 kann beispielsweise ein Beschleunigungssensor für ein Kraftfahrzeug sein und umfaßt ein an sich bekanntes Halbleitersubstrat 4 aus beispielsweise Silicium, auf dessen Oberseite 17 elektromechanische Strukturen 13 in einem Ätzprozeß hergestellt sind. Die Strukturen 13 auf dem Halbleitersubstrat sind mit einem Kappenteil 5 abgedeckt, welches ebenfalls aus einem Halbleitermaterial, beispielsweise Silicium gefertigt ist und beispielsweise mittels einer umlaufenden Dichtung aus Glas oder in anderer Weise mit dem Halbleitersubstrat verbunden ist. Das Kappenteil 5 weist eine in einem Ätzprozeß hergestellte Ausnehmung 6 auf, welche über den Strukturen 13 angeordnet wird. Weiterhin sind Leiterbahnen 19 zur elektrischen Kontaktierung der Bauteile 13 auf der Oberseite 17 des Halbleitersubstrats 4 angeordnet.

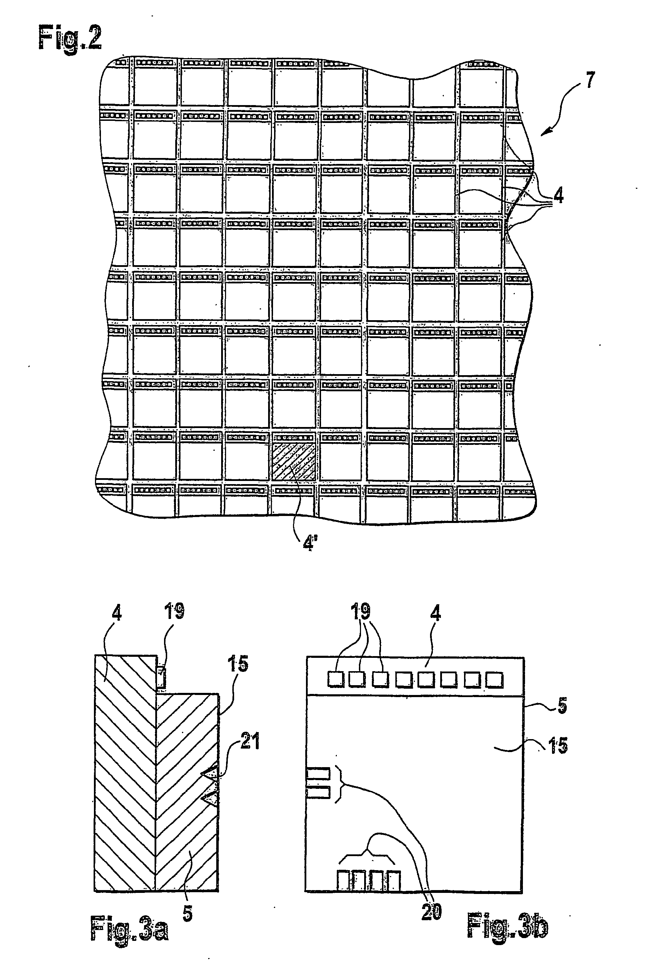

Die Herstellung des Halbleitersubstrat erfolgt üblicherweise im Nutzen auf einem gemeinsamen Basissubstrat, welches beispielsweise ein Silicium-Wafer ist. Ein Ausschnitt eines solchen Basissubstrats 7 ist in Fig. 2 gezeigt. Die einzelnen Halbleitersubstrate werden auf dem Basissubstrat im Nutzen gefertigt, wobei jedes Halbleitersubstrat mit elektronischen und/oder elektromechanischen Bauteilen 13 und Leiterbahnen 19 versehen wird. Danach werden die Halbleitersubstrate 4 mit je einem Kappenteil 5 abgedeckt und vereinzelt. Die Vereinzelung erfolgt üblicherweise durch Zersägen des Wafers. Anschließend werden die Halbleitersubstrate 4 mit der Unterseite 18 einzeln auf einen Montageabschnitt 12 eines Leitungsgitters, ein sogenanntes Leadframe, aufgebracht und die Leiterbahnen 19 der Halbleitersubstrate 4 mit Kontaktabschnitten 11 des Leadframes über Bonddrähte 16 verbunden. Danach werden die Kontaktabschnitte 11 des Leitungsgitters beispielsweise durch Stanzen oder Schneiden voneinander getrennt und das Halbleitersubstrat 4 zusammen mit dem Kappenteil 5 in einem Spritzwerkzeug bis auf die Enden der Kontaktabschnitte 11 mit einem Gehäuseteil 8 aus Spritzmasse (Mold compound) umgeben. Die Spritzmasse kann beispielsweise ein Duroplast sein. Das fertige Halbleiterbauelement 1 ist in Fig. 1 gezeigt.

Bei einem Ausführungsbeispiel des erfindungsgemäßen Halbleiterbauelementes ist es vorgesehen, die Innenseite 22 des Kappenteils 5 mit einer Kennung 20 zu versehen, welche aus einem Muster von kerbenartigen Vertiefungen 21 besteht. Die Vertiefungen 21 können durch Ätzen des Kappenteils ausgebildet werden und weisen vorzugsweise schräg zur Innenseite 22 des Kappenteils 5 verlaufende Innenwände auf. Die Kennung 20 beinhaltet einen Codierung, beispielsweise einen Binärcode, aus dem sich die ursprüngliche Position des Halbleitersubstrats 4 auf dem Basissubstrat erkennen läßt. Nach dem Umspritzen ist die Kennung 20 optisch nicht mehr erkennbar. Da sich die Halbleiterbauelemente 1 äußerlich nicht unterscheiden, ist eine optische Identifizierung eines ausgewählten Halbleiterbauelementes nicht möglich. Jedoch kann durch Einstrahlen einer Ultraschallwelle mittels einer Ultraschalleinrichtung, welche einen Ultraschallsender und einen Ultraschallempfänger umfaßt, die Kennung 20 auch ohne Öffnen des Gehäuseteils 8 ausgelesen werden. Da die Ultraschallwelle das Gehäuseteil 8 durchdringt, kann durch Messung von Unterschieden des Laufwegs der eingestrahlten und empfangenen Ultraschallwelle oder durch Messen von Reflexionsunterschieden ein Abbild des Flächenabschnitts 22 mit der Kennung 20 erzeugt und ausgewertet werden. Da die Ultraschallwelle an den Vertiefungen 21 anders reflektiert wird als an dem Flächenabschnitt 22, wird die Kennung 20 von der Ultraschalleinrichtung erfaßt und kann bildlich dargestellt werden. Vorzugsweise wird hierfür ein Ultraschallmikroskop verwandt. Durch Auswertung der Kennung ist es möglich, die ursprüngliche Position des in dem Halbleiterbauelement eingebetteten Halbleitersubstrats 4' auf dem Basissubstrat 7 zurückzuverfolgen.

Die Kennung 20 kann auch auf der von dem Halbleitersubstrat 4 abgewandten Seite des Kappenteils 5 angeordnet sein, wie dies in Fig. 3a und Fig. 3b dargestellt ist. Weiterhin besteht die Möglichkeit die Kennung 20 auch unmittelbar auf dem Halbleitersubstrat 4 anzuordnen. Ferner muß die Kennung 20 nicht notwendiger Weise durch Vertiefungen gebildet werden. So ist es beispielsweise auch möglich, die auf dem Halbleitersubstrat oder einem darauf angeordneten Bauteil befindliche Kennung durch Auftragen eines Musters beziehungsweise einer strukturierten Beschichtung zu bilden. Die Beschichtung kann aus einer einzelnen Materialschicht oder einem Schichtsystem aus verschiedenen Materialien besteht, in dem sich Ultraschall mit einer anderen Geschwindigkeit ausbreitet als in dem Material des Halbleitersubstrats oder des Bauteils.

In einem weiteren Ausführungsbeispiel ist vorgesehen, die Reflexion der Ultraschallwelle durch eine Veränderung des Haftvermögens des Gehäusematerials auf dem Halbleitersubstrat zu beeinflussen. Beispielsweise kann die auf dem Halbleitersubstrat oder einem darauf angeordneten Bauteil angeordnete Kennung durch ein Muster gebildet werden, das aus einem Material besteht, an dem die Spritzmasse schlechter haftet als am Material des Halbleitersubstrats oder des Bauteils. Dies kann beispielsweise dadurch erreicht werden, daß die Kennung durch ein Muster aus Silberflecken gebildet wird. Durch Delamination der Spritzmasse an den mit den Silberflecken versehenen Stellen der Oberfläche des Halbleitersubstrats verändert sich die Reflexion der eingestrahlten Ultraschallwelle, so daß die Kennung mittels eines Ultraschallempfängers ausgelesen werden kann. Entsprechend ist es möglich, die auf dem Halbleitersubstrat oder einem darauf angeordneten Bauteil angeordnete Kennung durch ein Muster zu bilden, das aus einem Material besteht, an dem die Spritzmasse besser haftet als am Material des Halbleiterbauelementes oder des Bauteils. Beispielsweise kann die Kennung auf dem Halbleiterbauelement durch ein Muster aus Polyimidflecken gebildet werden, an dem die Spritzmasse des Gehäuseteils besser haftet als an dem Halbleitersubstrat.

## Patentansprüche

1. Halbleiterbauelement mit wenigstens einem mit elektronischen/elektromechanischen Bauteilen (13) versehenen Halbleitersubstrat (4), welches bis auf seine Anschlüsse (11) in ein Gehäuseteil (8) aus Kunststoff eingebettet ist, **dadurch gekennzeichnet, dass** das in dem Gehäuseteil (8) angeordnete Halbleitersubstrat (4) mit einer mittelbar oder umittelbar auf dem Halbleitersubstrat (4) angeordneten Kennung (20) versehen ist, welche eine Unterscheidung des Halbleiterbauelementes (1) von anderen gleichartig aufgebauten Halbleiterbauelementen ermöglicht und mittels Ultraschall von außerhalb des Gehäuseteils (8) auslesbar, jedoch optisch von außerhalb des Gehäuseteils (8) nicht erkennbar ist.

2. Halbleiterbauelement nach Anspruch 1, **dadurch gekennzeichnet, daß** die Kennung (20) durch ein Muster von Vertiefungen (21) in einem Flächenabschnitt (15,22) des Halbleitersubstrats (4) oder eines darauf angeordneten Bauteils (5) gebildet wird.

3. Halbleiterbauelement nach Anspruch 2, **dadurch gekennzeichnet, daß** die Vertiefungen (21) durch Ätzen hergestellt sind.

4. Halbleiterbauelement nach Anspruch 2, **dadurch gekennzeichnet, daß** die Innenwände der Vertiefungen (21) gegenüber dem Flächenabschnitt (15,22) geneigt sind.

5. Halbleiterbauelement nach einem der Ansprüche 2 bis 4, **dadurch gekennzeichnet, daß** die Vertiefungen (21) an einer dem Halbleitersubstrat (4) zugewandten Innenseite (22) eines auf dem Halbleitersubstrat (4) angeordneten Kappenteils (5) ausgebildet sind, welches Kappenteil (5) mit dem Halbleitersubstrat (4) einen Hohlraum (6) einschließt.

6. Halbleiterbauelement nach Anspruch 1, **dadurch gekennzeichnet, daß** die auf dem Halbleitersubstrat oder dem Bauteil angeordnete Kennung durch ein Muster gebildet wird, das aus einer Materialschicht oder einem Schichtsystem aus verschiedenen Materialien besteht, in dem sich Ultraschall mit einer anderen Geschwindigkeit ausbreitet als in dem Material des Halbleitersubstrats oder des Bauteils.

7. Halbleiterbauelement nach Anspruch 1, **dadurch gekennzeichnet, daß** das Gehäuseteil aus Spritzmasse gebildet ist und die auf dem Halbleitersubstrat oder einem darauf angeordneten Bauteil angeordnete Kennung durch ein Muster gebildet wird, das aus einem Material besteht, an dem die Spritzmasse schlechter haftet als am Material des Halbleitersubstrats oder des Bauteils.

8. Halbleiterbauelement nach Anspruch 7, **dadurch gekennzeichnet, daß** die Kennung durch ein Muster aus Silberflecken gebildet wird.

9. Halbleiterbauelement nach Anspruch 1, **dadurch gekennzeichnet, daß** das Gehäuseteil aus Spritzmasse gebildet ist und die auf dem Halbleitersubstrat oder einem darauf angeordneten Bauteil angeordnete Kennung durch ein Muster gebildet wird, das aus einem Material besteht, an dem die Spritzmasse besser haftet als am Material des Halbleiterbauelementes oder des Bauteils.

10. Halbleiterbauelement nach Anspruch 9, **dadurch gekennzeichnet, daß** die Kennung auf dem Halbleiterbauelement durch ein Muster aus Polyimidflecken gebildet wird.

11. Verfahren zur Identifizierung eines Halbleiterbauelementes, das wenigstens ein mit elektronischen/elektromechanischen Bauteilen (13) versehenes Halbleitersubstrat (4) aufweist, das zusammen mit einer Vielzahl weiterer Halbleitersubstrate (4) auf einem gemeinsamen Basissubstrat (7) im Nutzen hergestellt wird, wobei die Halbleitersubstrate (4) nach der Herstellung vereinzelt und auf ein Leiturigsgitter (11, 12) aufgebracht werden und schließlich bis auf ihre jeweiligen Anschlüsse (11) mit einem Gehäuseteil (8) aus Kunststoff umgeben werden, **dadurch gekennzeichnet, dass** alle Halbleitersubstrate (4) des Nutzens vor der Vereinzelung mit einer die Position des jeweiligen Halbleitersubstrats auf dem Basissubstrat (7) bezeichnenden, mittelbar oder unmittelbar auf dem Halbleitersubstrat (4) angeordneten Kennung (20) versehen werden und die Kennung (20) eines ausgewählten Halbleitersubstrats (4') nach dem Vereinzeln und Einbringen in das Gehäuseteil (8) zur Identifizierung des Halbleiterbauelementes (1) mittels einer Ultraschalleinrichtung von außerhalb des Gehäuseteils (8) ausgelesen wird.

12. Verfahren nach Anspruch 11, **dadurch gekennzeichnet, daß** als Ultraschalleinrichtung ein Ultraschallmikroskop verwandt wird.

## Claims

1. Semiconductor device comprising at least one semiconductor substrate (4) which is provided with electronic/electromechanical components (13) and is embedded apart from its terminals (11) into a housing part (8) composed of plastic, **characterized in that** the semiconductor substrate (4) arranged in the housing part (8) is provided with an identifier (20) arranged indirectly or directly on the semiconductor substrate (4), which identifier enables the semiconductor device (1) to be differentiated from other semiconductor devices of the same type and can be read from outside the housing part (8) by means of ultrasound, but cannot be detected optically from outside the housing part (8).

2. Semiconductor device according to Claim 1, **characterized in that** the identifier (20) is formed by a pattern of depressions (21) in a surface section (15, 22) of the semiconductor substrate (4) or of a component (5) arranged thereon.

3. Semiconductor device according to Claim 2, **characterized in that** the depressions (21) are produced by etching.

4. Semiconductor device according to Claim 2, **characterized in that** the inner walls of the depressions (21) are inclined with respect to the surface section (15, 22).

5. Semiconductor device according to any of Claims 2 to 4, **characterized in that** the depressions (21) are formed on an inner side (22) of a cap part (5) arranged on the semiconductor substrate (4), said inner side facing the semiconductor substrate (4), which cap part (5) together with the semiconductor substrate (4) encloses a cavity (6).

6. Semiconductor device according to Claim 1, **characterized in that** the identifier arranged on the semiconductor substrate or the component is formed by a pattern comprising a material layer or a layer system composed of different materials, in which ultrasound propagates at a different speed from that in the material of the semiconductor substrate or of the component.

7. Semiconductor device according to Claim 1, **characterized in that** the housing part is formed from moulding compound and the identifier arranged on the semiconductor substrate or a component arranged thereon is formed by a pattern comprising a material to which the moulding compound adheres more poorly than to the material of the semiconductor substrate or of the component.

8. Semiconductor device according to Claim 7, **characterized in that** the identifier is formed by a pattern of silver spots.

9. Semiconductor device according to Claim 1, **characterized in that** the housing part is formed from moulding compound and the identifier arranged on the semiconductor substrate or a component arranged thereon is formed by a pattern comprising a material to which the moulding compound adheres better than to the material of the semiconductor substrate or of the component.

10. Semiconductor device according to Claim 9, **characterized in that** the identifier on the semiconductor device is formed by a pattern of polyimide spots.

11. Method for identifying a semiconductor device having at least one semiconductor substrate (4) which is provided with electronic/electromechanical components (13) and is produced together with a multiplicity of further semiconductor substrates (4) on a common base substrate (7) in a panel, the semiconductor substrates (4), after production, being singulated and applied to a leadframe (11, 12) and finally being surrounded, apart from their respective terminals (11), with a housing part (8) composed of plastic, **characterized in that** all the semiconductor substrates (4) in the panel, prior to singulation, are provided with an identifier (20) arranged indirectly or directly on the semiconductor substrate (4) and designating the position of the respective semiconductor substrate on the base substrate (7), and the identifier (20) of a selected semiconductor substrate (4'), after singulation and introduction into the housing part (8), is read from outside the housing part (8) by means of an ultrasonic device for the purpose of identifying the semiconductor device (1).

12. Method according to Claim 11, **characterized in that** an ultrasonic microscope is used as the ultrasonic device.

## Revendications

1. Composant semi-conducteur qui présente au moins un substrat semi-conducteur (4) doté de composants électroniques ou électromécaniques (13) incorporé jusqu'à ses bornes de raccordement (11) dans une pièce de boîtier (8) en matière synthétique,
**caractérisé en ce que**
le substrat semi-conducteur (4) disposé dans la pièce de boîtier (8) est doté d'une identification (20) disposée directement ou indirectement sur le substrat semi-conducteur (4), qui permet de distinguer le composant semi-conducteur (1) d'autres composants semi-conducteurs de structure similaire et qui peut être lue par ultrasons depuis l'extérieur de la pièce de boîtier (8) mais qui ne peut pas être détectée optiquement de l'extérieur de la pièce de boîtier (8).

2. Composant semi-conducteur selon la revendication 1, **caractérisé en ce que** l'identification (20) est formée d'un motif de creux (21) ménagé dans une partie de surface (15, 22) du substrat semi-conducteur (4) ou d'un composant (5) qui est disposé sur celui-ci.

3. Composant semi-conducteur selon la revendication 2, **caractérisé en ce que** les creux (21) sont réalisés par gravure.

4. Composant semi-conducteur selon la revendication 2, **caractérisé en ce que** les parois intérieures des creux (21) sont inclinées par rapport à la partie de surface (15, 22).

5. Composant semi-conducteur selon l'une des revendications 2 à 4, **caractérisé en ce que** les creux (21) sont formés sur un côté intérieur (22), tourné vers le substrat semi-conducteur (4), d'une pièce de capuchon (5) disposée sur le substrat semi-conducteur (4), la pièce de capuchon (5) enfermant une cavité (6) avec le substrat semi-conducteur (4).

6. Composant semi-conducteur selon la revendication 1, **caractérisé en ce que** l'identification disposée sur le substrat semi-conducteur ou sur le composant est formée par un motif constitué d'une couche de matière ou d'un système stratifié formé de différents matériaux et dans lequel les ultrasons se propagent à une autre vitesse que dans le matériau du substrat semi-conducteur ou du composant.

7. Composant semi-conducteur selon la revendication 1, **caractérisé en ce que** la pièce de boîtier est formée d'une pâte d'injection et **en ce que** l'identification disposée sur le substrat semi-conducteur ou sur un composant qui est disposé sur celui-ci est formée d'un motif constitué d'un matériau sur lequel la pâte d'injection adhère moins bien que sur le matériau du substrat semi-conducteur ou du composant.

8. Composant semi-conducteur selon la revendication 7, **caractérisé en ce que** l'identification est formée d'un motif de taches d'argent.

9. Composant semi-conducteur selon la revendication 1, **caractérisé en ce que** la pièce de boîtier est formée d'une pâte d'injection et **en ce que** l'identification disposée sur le substrat semi-conducteur ou sur un composant qui est disposé sur celui-ci est formée d'un motif constitué d'un matériau sur lequel la pâte d'injection adhère mieux que sur le matériau du composant semi-conducteur ou du composant.

10. Composant semi-conducteur selon la revendication 9, **caractérisé en ce que** l'identification est formée sur le composant semi-conducteur par un motif de taches de polyimide.

11. Procédé d'identification d'un composant semi-conducteur qui présente au moins un substrat semi-conducteur (4) doté de composants électroniques ou électromécaniques (13) et qui est réalisé avantageusement avec plusieurs autres substrats semi-conducteurs (4) sur un substrat de base (7) commun, les substrats semi-conducteurs (4) étant séparés après leur fabrication et placés sur une grille conductrice (11, 12) pour enfin être englobés dans une pièce de boîtier (8) en matière synthétique jusqu'à leurs bornes de raccordement (11) respectives,
**caractérisé en ce que**
tous les substrats semi-conducteurs (4) sont avantageusement dotés, avant la séparation, d'une identification (20) disposée directement ou indirectement sur le substrat semi-conducteur (4) et désignant la position de chaque substrat semi-conducteur sur le substrat de base (7) et
**en ce que** pour identifier le composant semi-conducteur (1), l'identification (20) d'un substrat semi-conducteur (4') sélectionné est lue à l'aide d'un dispositif à ultrasons depuis l'extérieur de la pièce de boîtier (8) après la séparation et le placement dans la pièce de boîtier (8).

12. Procédé selon la revendication 11, **caractérisé en ce qu'**il utilise comme dispositif à ultrasons un microscope à ultrasons.
